# EUROPEAN PATENT APPLICATION

(11) **EP 4 694 597 A1**
(43) Date of publication of application: **11.02.2026**
(21) Application number: 24779764.0
(22) Date of filing: 19.03.2024
(51) Int. Cl.: H05K 7/20, G02B 6/42

(54) **SUBSTRATE ASSEMBLY**

(30) Priority: 31.03.2023 JP 2023057805
(71) Applicant: FURUKAWA ELECTRIC CO., LTD., Tokyo 100-8322 (JP)
(72) Inventor: ISHIGE, Yuta, Tokyo 100-8322 (JP); NAGASHIMA, Kazuya, Tokyo 100-8322 (JP); YOSHIDA, Wataru, Tokyo 100-8322 (JP); NASU, Hideyuki, Tokyo 100-8322 (JP); HIRASAWA, Takeshi, Tokyo 100-8322 (JP)
(74) Representative: SSM Sandmair
(86) International application number: PCT/JP2024/010804
(87) International publication number: WO 2024/203639

(57) **Abstract**

A board assembly includes a substrate that has a first surface facing in a first direction and a second surface facing in a direction opposite to the first direction on a side opposite to the first surface and to which an optical transceiver including a first electric interface and a heat dissipator that face in the direction opposite to the first direction are fixed; and a first heat dissipation mechanism that includes a connector adjacent to the heat dissipator in the first direction and thermally connected to the heat dissipator in a state where the optical transceiver is fixed to the substrate and that is fixed to the substrate and the board assembly is configured such that the optical transceiver is detachable in a state where the first dissipation mechanism is fixed to the substrate.

## Description

### Field

The present invention relates to a board assembly.

### Background

A compact optical transceiver described in Patent Literature 1 has been known as an optical transceiver that is used in a network switch device (for example, Patent Literature 1).

### Citation List

### Patent Literature

Patent Literature 1: Japanese Laid-open Patent Publication No. 2020-27147

### Summary

### Technical Problem

In a network switch device that realizes CPO (copackaged optics), an ASIC (application specific integrated circuit) and a plurality of optical transceivers are mounted on a substrate.

In the device, the optical transceivers are arranged on a substrate detachably in some cases for maintenance and replacement.

On the other hand, with an increase in communication traffic, in network switch devices of this type, not only an amount of heat generation of the switch ASIC but also an amount of heat generation of the optical transceivers tends to increase.

When a heat dissipation mechanism that dissipates heat generated in the optical transceivers is provided as a measure against it, it is crucial that the heat dissipation mechanism does not prevent replacement of the optical transceivers.

An object of the present invention is, for example, to obtain an improved and new board assembly in which it is possible to detach an optical transceiver easily as a board assembly including a substrate on which the optical transceiver is mounted and a heat dissipation mechanism.

### Solution to Problem

A board assembly according to the present invention includes: a substrate that has a first surface facing in a first direction and a second surface facing in a direction opposite to the first direction on a side opposite to the first surface and to which an optical transceiver including a first electric interface and a heat dissipator that face in the direction opposite to the first direction is fixed; and a first heat dissipation mechanism that includes a connector adjacent to the heat dissipator in the first direction and thermally connected to the heat dissipator in a state where the optical transceiver is fixed to the substrate and that is fixed to the substrate, the board assembly being configured such that the optical transceiver is detachable in a state where the first dissipation mechanism is fixed to the substrate, for example.

In the board assembly, the optical transceiver may be arranged on the substrate detachably in the first direction, and the first dissipation mechanism may be arranged out of alignment with the optical transceiver in the direction opposite to the first direction.

In the board assembly, the optical transceiver may be arranged on the substrate detachably in the first direction, and the first dissipation mechanism may be arranged out of alignment with the optical transceiver in a direction intersecting with the first direction.

In the board assembly, the optical transceiver may be arranged on the substrate detachably in the first direction, and the first dissipation mechanism may have a portion out of alignment with the optical transceiver in the direction opposite to the first direction and a portion out of alignment with the optical transceiver in a direction intersecting with the first direction.

In the board assembly, the first heat dissipation mechanism may be configured to perform heat transfer with a liquid refrigerant.

The board assembly may further include a second heat dissipation mechanism that is thermally connected to a semiconductor integrated circuit mounted on the first surface, and the board assembly may be configured such that the optical transceiver is detachable in a state where the second dissipation mechanism is fixed to the semiconductor integrated circuit.

In the board assembly, the second heat dissipation mechanism may be configured to perform heat transfer with a liquid refrigerant.

In the board assembly, the first heat dissipation mechanism may be configured to perform heat transfer with a liquid refrigerant, and a flow channel for the liquid refrigerant in the first heat dissipation mechanism and a flow channel for the liquid refrigerant in the second heat dissipation mechanism may be arranged in parallel.

In the board assembly, the substrate may be configured such that a plurality of optical transceivers are fixable as the optical transceiver.

In the board assembly, the plurality of optical transceivers may be arranged along a side of the substrate.

In the board assembly, the first heat dissipation mechanism may be arranged along the side of the substrate.

In the board assembly, a second electric interface that is fixed to the substrate and that is electrically connected to the first electric interface may include an electric conductor and an electric insulator having a thermal conductivity lower than a thermal conductivity of the heat dissipator.

### Advantageous Effects of Invention

According to the present invention, for example, it is possible to obtain an improved and new board assembly in which it is possible to detach an optical transceiver easily as a board assembly including a substrate on which the optical transceiver is mounted and a heat dissipation mechanism.

### Brief Description of Drawings

FIG. 1 is an exemplary and schematic perspective view of a switch device of a first embodiment.
FIG. 2 is an exemplary and schematic plane view of the switch device of the first embodiment.
FIG. 3 is an exemplary and schematic side view of part of the switch device of the first embodiment.
FIG. 4 is a IV-IV cross-sectional view of FIG. 2.
FIG. 5 is an exemplary and schematic perspective view of a switch device of a second embodiment.
FIG. 6 is an exemplary and schematic plane view of the switch device of the second embodiment.
FIG. 7 is an exemplary and schematic side view of part of the switch device of the second embodiment.
FIG. 8 is an exemplary and schematic cross-sectional view of part of a switch device of a third embodiment.
FIG. 9 is an exemplary and schematic exploded cross-sectional view of part of a switch device of a fourth embodiment.

### Description of Embodiments

Exemplary embodiments and modifications of the present invention will be disclosed below. Configurations of the embodiments and the modifications presented below and the functions and results (effects) brought by the configurations are an example. The present invention can be realized also by configurations other than those disclosed in the following embodiments and modifications. According to the present invention, it is possible to obtain at least one of various effects (including derivative effects) that are obtained with the configurations.

The embodiments and modifications presented below have similar components. Common reference numerals are assigned to the similar components and redundant description is sometimes omitted below.

In the specification, ordinal numbers can be assigned for convenience in order to distinguish directions, parts, members, mechanisms, etc. Ordinal numbers do not represent priorities and an order and do not specify the numbers.

In each of the drawings, an X-direction is represented by an arrow X, a Y-direction is represented by an arrow Y, and a Z-direction is represented by an arrow Z. The X-direction, the Y-direction, and the Z-direction intersect with one another and are orthogonal to one another.

### First Embodiment

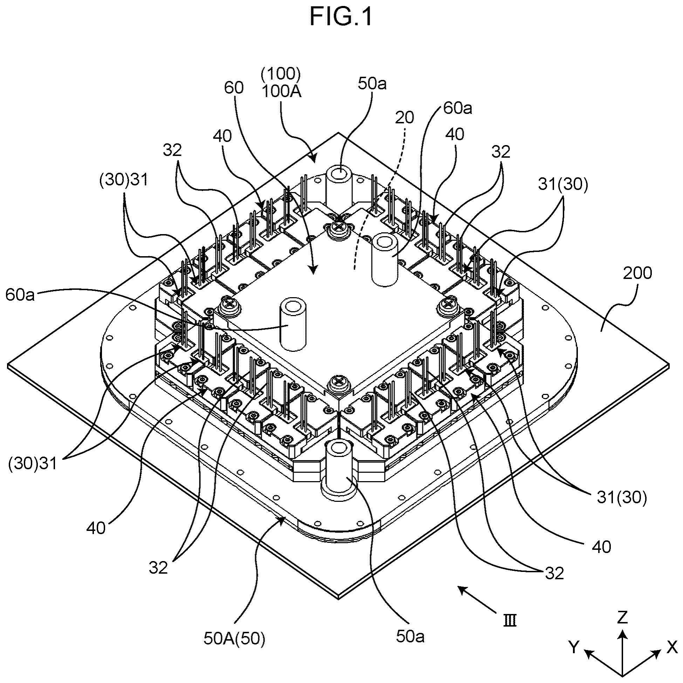

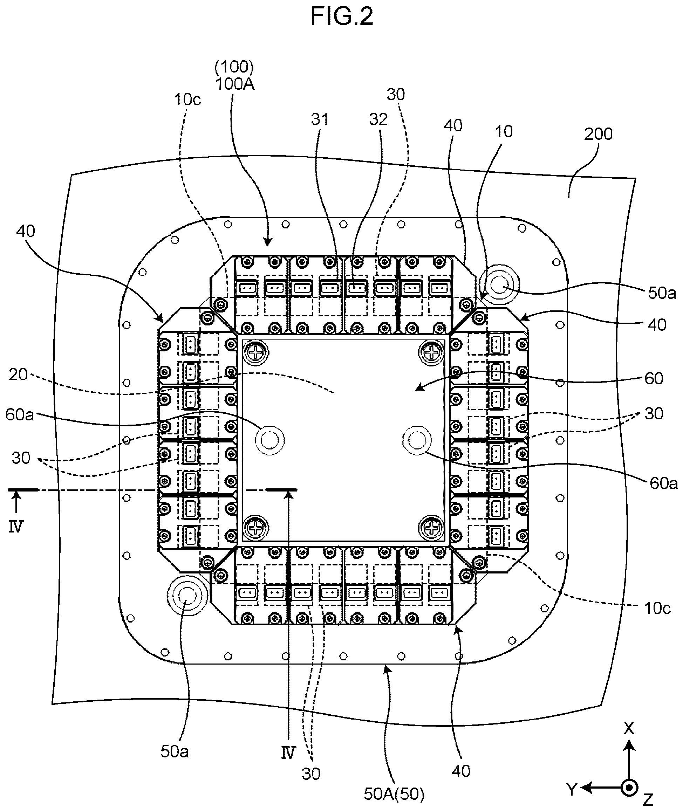

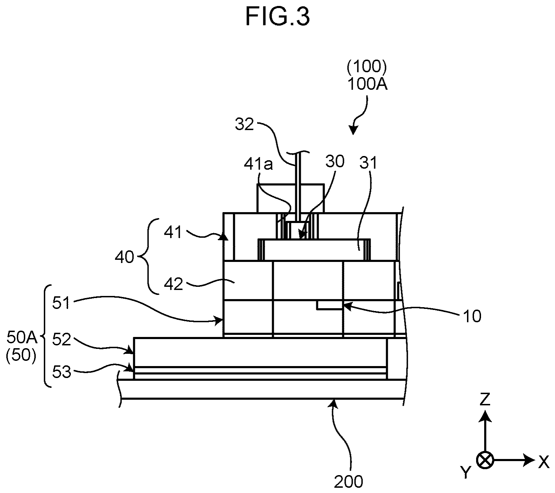

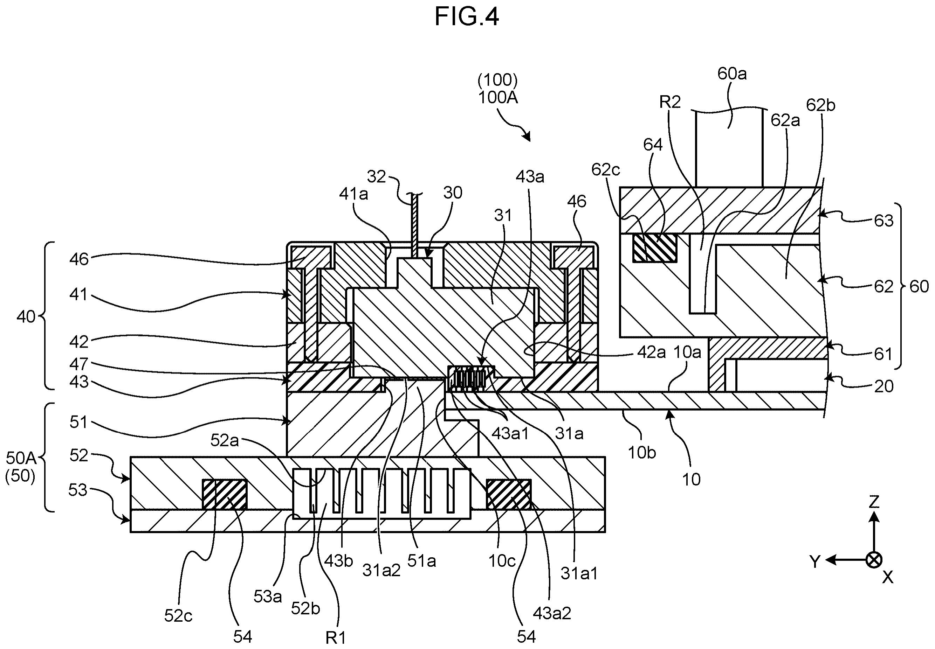

FIG. 1 is a perspective view of a switch device 100A (100) of a first embodiment. FIG. 2 is a plane view of the switch device 100A (100). FIG. 3 is a side view of part of the switch device 100A (100) viewed in the Y-direction in Arrow III in FIG. 1. FIG. 4 is a IV-IV cross-sectional view of FIG. 2.

As illustrated in FIG. 1, the switch device 100 is mounted on a motherboard 200. In the present embodiment, only the single switch device 100 is mounted on the motherboard 200; however, a plurality of the switch devices 100 may be mounted on the motherboard 200. The motherboard 200 can be also referred to as an integrated board.

As illustrated in FIGS. 1 and 2, the switch device 100 includes a substrate 10, a switch ASIC 20, a plurality of optical transceivers 30, a heat dissipation mechanism 60 for the switch ASIC 20, a fixation mechanism 40 that fixes the optical transceiver 30 to the substrate 10, and a heat dissipation mechanism 50A (50) for the optical transceiver 30. The substrate 10, the fixation mechanism 40, and the heat dissipation mechanisms 50 and 60 of the switch device 100 are referred to as a board assembly. The board assembly can be mounted on the motherboard 200.

As illustrated in FIG. 2, the substrate 10 has a square shape (rectangular shape). As illustrated in FIG. 4, the substrate 10 includes a surface 10a that intersects with and is orthogonal to the Z-direction, that extends, that has a platy shape, and that faces in the Z-direction and a surface 10b that faces in a direction opposite to the Z-direction on a side opposite to the surface 10a. The surfaces 10a and 10b intersect with and are orthogonal to the Z-direction and extend. The substrate 10 is, for example, a printed circuit board. The Z-direction is an example of a first direction of the substrate 10 and is also referred to as a thickness direction of the substrate 10. The surface 10a is an example of the first face and the surface 10b is an example of a second face.

Each of the optical transceivers 30 illustrated in FIGS. 1 to 4 receives an optical signal that is transmitted via an optical fiber 32 and outputs an electric signal corresponding to the optical signal. The electric signal that is output from the optical transceiver 30 is input to the switch ASIC 20 via an electric conductor arranged in a socket 43 (refer to FIG. 4) and the substrate 10. The optical transceiver 30 includes a photodiode array (not illustrated in the drawing) as a plurality of optical receivers that receive an optical signal. Each of the optical transceivers 30 receives an electric signal from the switch ASIC 20 via the electric conductor arranged in the substrate 10 and the socket 43 and outputs an optical signal corresponding to the electric signal. The optical signal that is output from the optical transceiver 30 is coupled to the optical fiber 32 and is transmitted via the optical fiber 32. The optical transceiver 30 includes, for example, a VCSEL array (not illustrated in the drawing, VCSEL: vertical cavity surface emitting laser) as a plurality of light emitters that outputs an optical signal.

As illustrated in FIG. 2, the optical transceivers 30 are arranged along each side 10c of the substrate 10. In the present embodiment, as illustrated in FIG. 4, each of the optical transceivers 30 is mounted such that the optical transceiver 30 covers the side 10c. In other words, when viewed on the side opposite to the Z-direction, each of the optical transceivers 30 is formed such that the optical transceiver 30 straddles the side 10c and has a portion positioned on an inner side with respect to the side 10c and a portion positioned on an outer side with respect to the side 10c. This achieves an advantage that interference between the optical fiber 32 extending from the optical transceiver 30 and other parts, such as the switch ASIC 20 and the heat dissipation mechanism 60 that are mounted on the substrate 10, is likely to be avoided and the substrate 10 can be formed smaller.

As illustrated in FIG. 1 and 2, the optical transceivers 30 are fixed by the fixation mechanism 40 that is arranged on each of the sides 10c of the substrate 10. The fixation mechanism 40 is arranged on each of the four sides 10c, that is, four fixation mechanisms are provided in total and the fixation mechanisms 40 are shared with respect to a plurality of (eight as an example in the present embodiment) the optical transceivers 30 that are arranged along each of the sides 10c. Sharing the fixation mechanism 40 with respect to the optical transceivers 30 as described above, for example, achieves an advantage that, compared to the case where the optical transceivers 30 are fixed by the respective fixation mechanisms to the substrate 10, it is possible to further simplify the structure of the fixation mechanism 40 attached to the substrate 10, further reduce the number of parts, and eventually reduce the time for and costs of manufacturing the switch device 100.

As illustrated in FIGS. 1 and 2, the switch ASIC 20 is mounted on the substrate 10 in a position separate from each of the sides 10c of the substrate 10 (in the present embodiment, approximately at the center of the substrate 10 as an example). As illustrated in FIG. 4, the switch ASIC 20 is mounted on the surface 10a by, for example, flip-chip packaging. The switch ASIC 20 controls operations of each of the optical transceivers 30. The switch ASIC 20 is an example of a semiconductor integrated circuit.

As illustrated in FIG. 4, the heat dissipation mechanism 60 is arranged such that the heat dissipation mechanisms 60 makes contact with the switch ASIC 20 on a side opposite to the substrate 10. The heat dissipation mechanism 60 is an example of a second heat dissipation mechanism. The heat dissipation mechanism 60 is an example of a second heat dissipation mechanism. The heat dissipation mechanism 60 will be described below.

As illustrated in FIGS. 3 and 4, in the present embodiment, the fixation mechanism 40 includes an upper member 41, an intermediate member 42, and the socket 43 as an example. These components of the fixation mechanism 40 are integrated by a fixation member 46 like a screw. Among the components of the fixation mechanism 40, the intermediate member 42 and the socket 43 among the components of the fixation mechanism 40 are shared with respect to all the optical transceivers 30 of the group of the optical transceivers 30 along the side 10c of the substrate 10. As illustrated in FIG. 4, in a state of sandwiching the optical transceivers 30 positioned near the side 10c of the substrate 10 in a thickness direction of the substrate 10, the fixation mechanism 40 fixes the optical transceivers 30 to the substrate 10.

To allow replacement after the optical transceivers 30 are mounted, the fixation mechanism 40 includes components that are fixed to the substrate 10 and components detachable from the substrate 10. In the present embodiment, the intermediate member 42 and the socket 43 are fixed to the substrate 10 and the upper member 41 is configured detachably from the intermediate member 42, that is, the substrate 10. Specifically, as illustrated in FIG. 4, the upper member 41 is attached to the intermediate member 42 with the fixation member 46 that is configured as a detachable screw. The optical transceiver 30 is detachable by being moved in the Z-direction and is attachable by being moved in the direction opposite to the Z-direction. The optical transceiver 30 is fixed to the substrate 10 detachably via the fixation mechanism 40 having such a configuration.

In the present embodiment, the upper member 41 is not shared with respect to all the optical transceivers 30 along the side 10c but is shared with respect to only two transceivers 30 that are adjacent along the side 10c. This, for example, achieves an advantage that both facilitating individual detachment of the optical transceivers 30 and sharing the parts are enabled and that it is possible to further increase accuracy in positioning by reducing the effect of deflection of the fixation mechanism 40 and production tolerance of the components of the fixation mechanism 40 and the optical transceivers 30, etc. Such a configuration however is an example and the upper member 41 may be shared with respect to all the optical transceivers 30 along the side 10c.

As illustrated in FIG. 4, the optical transceiver 30 includes a body 31 and a plurality of optical fibers 32 (refer to FIG. 1). In the following description, unless otherwise specified, a state where the optical transceivers 30 are fixed to the substrate 10 will be described.

The body 31 has a surface 31a facing in the direction opposite to the Z-direction. The surface 31a is provided with an electric interface 31a1 in which an array of a plurality of electrodes (not illustrated in the drawing) are formed and a heat dissipation surface 31a2. In a fixed state, both the electric interface 31a1 and the heat dissipation surface 31a2 face in the direction opposite to the Z-direction and are aligned approximately along the surface 10a of the substrate 10 and in a direction intersecting with the side 10c of the substrate 10 (in the X-direction in the optical transceiver 30 illustrated in FIG. 4). A heat generator in the optical transceiver 30 is aligned with the heat dissipation surface 31a2 in the Z-direction. The heat dissipation surface 31a2 is an example of a heat dissipator. The electric interface 31a1 is an example of a first electric interface.

The optical fibers 32 extend from a portion separate from the surface 31a of the body 31, specifically, a portion aligned with the heat dissipation surface 31a2 in the Z-direction on a side opposite to the heat dissipation surface 31a2. The optical fibers 32 extend from the body 31 in the Z-direction in the vicinity of the body 31.

The socket 43, the intermediate member 42, and the upper member 41 are mounted on the substrate 10 in this order.

The upper member 41 pushes the body 31 of the optical transceiver 30 toward the substrate 10 and the socket 43 in the direction opposite to the Z-direction. As illustrated in FIG. 4, an opening 41a serving as a cutout penetrating the upper member 41 in the Z-direction is formed in the upper member 41. The body 31 is partly housed in the opening 41a and the optical fiber 32 extends through the opening 41a.

An opening 42a extending in the Z-direction and serving as a through-hole is formed in the intermediate member 42. A side surface of the opening 42a has a function of roughly guiding in the X-direction and the Y-direction when the body 31 of the optical transceiver 30 is mounted.

The socket 43 is mounted on the surface 10a of the substrate 10 and supports the body 31 of the optical transceiver 30. The socket 43 is provided with an electric interface 43a and an opening 43b. The electric interface 43a is an example of a second electric interface.

The electric interface 43a faces and makes contact with the electric interface 31a1 that is formed in the body 31 of the optical transceiver 30 and has an electric conductor 43a1 that is electrically connected to each of the electrodes that are formed in the electric interface 31a1. The electric conductor 43a1, for example, can be configured as a contact terminal that extends in the Z-direction and that has an elastically stretchable pin. The electric conductor 43a1 is electrically connected to the electric conductor (not illustrated in the drawing) of the substrate 10. Each of the electrodes of the electric interface 31a1 of the optical transceiver 30 is electrically connected to an electric conductor of the switch ASIC 20 via the electric conductor 43a1 of the electric interface 43a of the socket 43 and the electric conductor of the substrate 10. Including the socket 43 with the electric interface 43a, for example, achieves an advantage that it is possible to make a configuration that ensures required accuracy in positioning the electrodes more easily compared to the case where the electric interface 43a is arranged directly on the substrate 10. Note that, in the electric interface 43a, a thermal conductivity of an electric insulator 43a2 that is positioned around the electric conductor 43a1 and that supports the electric conductor 43a1 is lower than a thermal conductivity of the heat dissipation surface 31a2.

The opening 43b exposes the heat dissipation surface 31a2 that is formed in the body 31 of the optical transceiver 30 in the direction opposite to the Z-direction. The opening 43b, for example, is formed as a through-hole penetrating the socket 43 in the Z-direction or a cutout.

The heat dissipation mechanism 50 dissipates heat generated in the optical transceiver 30. The heat dissipation mechanism 50 is an example of a first heat dissipation mechanism. The heat dissipation mechanism 50 will be described below.

As is clear from FIGS. 2 and 4, the heat dissipation surface 31a2 is positioned on a side opposite to the switch ASIC 20 with respect to the electric interface 31a1. Such arrangement, for example, makes it possible to further reduce the length of the electric conductor between the electric interface 31a1 and the switch ASIC 20, accordingly required transmission characteristics of an electric signal is ensured easily and it is possible to avoid interference between the first heat dissipation mechanism and the electric conductor, and accordingly required heat dissipation performance is obtained easily from the optical transceiver 30.

### Heat Dissipation Mechanism of Optical Transceiver

The heat dissipation mechanism 50 for the optical transceiver 30 includes a connecting member 51, a base member 52, a cover member 53, and a sealing member 54. The heat dissipation mechanism 50 is fixed to the substrate 10 or the fixation mechanism 40 with a fixation member, such as a screw, by adhesion, or the like. Note that at least the connecting member 51 in the heat dissipation mechanism 50 may be configured to function as part of the fixation mechanism 40.

The connecting member 51 is positioned on a side opposite to the intermediate member 42 with respect to the socket 43. The connecting member 51 includes a portion 51a that is housed in the opening 43b of the socket 43. The portion 51a is adjacent to the heat dissipation surface 31a2 of the optical transceiver 30 in the Z-direction and is connected thermally to the heat dissipation surface 31a2. The portion 51a is an example of a connector.

The portion 51a is adjacent to the heat dissipation surface 31a2 via a heat conducting sheet 47 that is flexible. Arranging the heat conducting sheet 47 achieves an advantage that it is possible to inhibit an efficiency of thermal conduction from the heat dissipation surface 31a2 to the portion 51a from lowering because of occurrence of a gap between the heat dissipation surface 31a2 and the portion 51a due to production tolerance, a difference in thermal expansion coefficient between parts, or the like, and inhibit occurrence of an excessive pressure between the heat dissipation surface 31a2 and the portion 51a.

The connecting member 51 is thermally connected to the base member 52 in a position different from the portion 51a. The connecting member 51 thus is able to transmit the heat generated in the optical transceiver 30 to the base member 52. The connecting member 51 can be also referred to as a heat transfer member.

The base member 52 is arranged on a side opposite to the optical transceiver 30 and the socket 43 with respect to the connecting member 51 and extends approximately along the sides 10c of the substrate 10 in an approximately rectangular form and a circumferential form (endless form) in an approximately certain width in a direction along the surface 10b and in an approximately certain thickness in the Z-direction.

The cover member 53 is arranged on a side opposite to the connecting member 51 with respect to the base member 52 and extends approximately along the sides 10c of the substrate 10 in an approximately rectangular form and a circumferential form (endless form) in a width approximately equal to that of the base member 52 in the direction along the surface 10b and in an approximately certain thickness in the Z-direction.

All the connecting member 51, the base member 52, and the cover member 53 are made of a material having a relatively high thermal conductivity. For example, a copper material, such as pure copper or a copper alloy, or an aluminum material, such as pure aluminum or an aluminum alloy, is taken as the material having a relatively high thermal conductivity and forming the members.

As illustrated in FIG. 4, the base member 52 and the cover member 53 form a storage chamber R1 in which a liquid refrigerant is stored. The storage chamber R1 is formed in a way that a circumferential groove 52a that is formed in the base member 52 and that is concave in the Z-direction and a groove 53a that is formed in the cover member 53 and that is concave in the direction opposite to the Z-direction are butted against with each other. Note that the concave portion may be formed in only one of the base member 52 and the cover member 53. Arrangement of and the shapes of the base member 52 and the cover member 53 that form the storage chamber R1 are not limited to the example in FIG. 4, and they may be changed variously and may be exploited. The base member 52 and the cover member 53 also can be referred to as a refrigerant storage.

In the present embodiment, the base member 52, the cover member 53, the groove 52a, the groove 53a, and the storage chamber R1 extend approximately along the sides 10c of the substrate 10 in an approximately rectangular form and a circumferential form (endless form). The connecting member 51 extends linearly approximately along the side 10c of the substrate 10 in a position where the connecting member 51 overlaps the optical transceivers 30 in the Z-direction.

At a boundary plane between the base member 52 and the cover member 53, liquid tightness is ensured by separate ring-like sealing members 54 on each of an inner circumferential side (right side in FIG. 4) and an outer circumferential side (left side in FIG. 4) with respect to the circumferential storage chamber R1. The sealing members 54 are made of, for example, elastomer. Each of the sealing members 54 is stored in a circumferential groove 52c that is formed in the base member 52 and, in a state where the base member 52 and the cover member 53 are integrated, the sealing member 54 is pressurized by the base member 52 and the cover member 53 elastically in the Z-direction, so that a sealing plane pressure is ensured.

The storage chamber R1 is formed such that the storage chamber R1 overlaps the heat dissipation surface 31a2 of the optical transceiver 30 and the portion 51a of the connecting member 51 at least partly in the Z-direction.

In the base member 52, a plurality of fin-like or pin-like protrusions 52b that protrude into the storage chamber R1 from an inner surface of the storage chamber R1 on a side close to the optical transceiver 30 are formed. The protrusions 52b increase an area of contact of the base member 52 with the liquid refrigerant. Accordingly, compared to the case where the protrusions 52b are not formed, it is possible to increase the amount of heat transfer from the base member 52 to the liquid refrigerant and further increase efficiency of heat dissipation by the heat dissipation mechanism 50.

As illustrated in FIG. 1, the heat dissipation mechanism 50 includes two connection ports 50a to which a channel forming member forming a flow channel for the liquid refrigerant, such as a pipe or a tube, is connected. One of the two connection ports 50a forms an inlet for the liquid refrigerant and the other one forms an outlet for the liquid refrigerant. The two connection ports 50a are connected to a heat exchanger (heat dissipator) via the channel forming member. In other words, the heat dissipation mechanism 50 is an example of a heat transport mechanism that performs heat transport using the liquid refrigerant.

### Heat Dissipation Mechanism for Switch ASIC

The heat dissipation mechanism 60 for the switch ASIC 20 includes a connecting member 61, a base member 62, a cover member 63, and a sealing member 64. The heat dissipation mechanism 60 is fixed to the substrate 10 or the fixation mechanism 40 with a fixation member, such as a screw, by adhesion, or the like.

The connecting member 61 is positioned on a side opposite to the substrate 10 with respect to the switch ASIC 20. The connecting member 61 is connected thermally to the switch ASIC 20 and is connected thermally to the base member 62 on a side opposite to the switch ASIC 20. Thus, the connecting member 61 is able to transfer the heat generated in the switch ASIC 20 to the base member 62. The connecting member 61 can be also referred to as a heat transfer member.

The base member 62 has a square and platy shape intersecting with and orthogonal to the Z-direction.

The cover member 63 is arranged on a side opposite to the connecting member 61 with respect to the base member 62 and has a square and platy shape intersecting with and orthogonal to the Z-direction.

All the connecting member 61, the base member 62, and the cover member 63 are made of a material having a relatively high thermal conductivity. For example, a copper material, such as pure copper or a copper alloy, or an aluminum material, such as pure aluminum or an aluminum alloy, is taken as the material having a relatively high thermal conductivity and forming the members.

As illustrated in FIG. 4, the base member 62 and the cover member 63 form a storage chamber R2 in which a liquid refrigerant is stored. The storage chamber R2 is formed in a way that a concave portion 62a that is concave in the direction opposite to the Z-direction and that is formed in the base member 62 and the cover member 63 that covers the concave portion 62a are butted against with each other. Note that the concave portion may be formed in the cover member 63 or may be formed in both the base member 62 and the cover member 63. Arrangement of and the shapes of the base member 62 and the cover member 63 that form the storage chamber R2 are not limited to the example in FIG. 4, and they may be changed variously and may be exploited. The base member 62 and the cover member 63 also can be referred to as a refrigerant storage.

At a boundary plane between the base member 62 and the cover member 63, liquid tightness is ensured by a circumferential sealing member 64 on an outer circumferential side (left side in FIG. 4) of the storage chamber R2. The sealing member 64 is made of, for example, elastomer. The sealing member 64 is stored in a circumferential groove 62c that is formed in the base member 62 and, in a state where the base member 62 and the cover member 63 are integrated, the sealing member 64 is pressurized by the base member 62 and the cover member 63 elastically in the Z-direction, so that a sealing plane pressure is ensured.

The storage chamber R2 is formed such that the storage chamber R2 partly overlaps the switch ASIC 20 and the connecting member 61 in the Z-direction.

In the base member 62, a plurality of fin-like or pin-like protrusions 62b that protrude into the storage chamber R2 from an inner surface of the storage chamber R2 on a side close to the switch ASIC 20 are formed. The protrusions 62b increase an area of contact of the base member 62 with the liquid refrigerant. Accordingly, compared to the case where the protrusions 62b are not formed, it is possible to increase the amount of heat transfer from the base member 62 to the liquid refrigerant and further increase efficiency of heat dissipation by the heat dissipation mechanism 60.

As illustrated in FIG. 1, the heat dissipation mechanism 60 includes two connection ports 60a to which a channel forming member forming a flow channel for the liquid refrigerant, such as a pipe or a tube, is connected. One of the two connection ports 60a forms an inlet for the liquid refrigerant and the other one forms an outlet for the liquid refrigerant. The two connection ports 60a are connected to a heat exchanger (heat dissipator) via the channel forming member. In other words, the heat dissipation mechanism 60 is an example of a heat transport mechanism that performs heat transport using the liquid refrigerant.

The flow channel for the liquid refrigerant in the heat dissipation mechanism 50 and the flow channel for the liquid refrigerant in the heat dissipation mechanism 60 are preferably arranged in parallel. Such a configuration makes it possible to further increase heat dissipation efficiency compared to the case where the flow channels for the liquid refrigerant in the heat dissipation mechanisms 50 and 60 are connected in series.

As described above, the optical transceivers 30 are arranged on the substrate 10 detachably in the Z-direction. On the other hand, the heat dissipation mechanism 50 is arranged out of alignment with the optical transceiver 30 in a direction opposite to the Z-direction. Accordingly, in the state of being fixed to the substrate 10, the heat dissipation mechanism 50 does not inhibit detachment of the optical transceiver 30.

On the other hand, the heat dissipation mechanism 60 is arranged out of alignment with the optical transceiver 30 in a direction intersecting with the Z-direction. Accordingly, in the state of being fixed to the substrate 10, the heat dissipation mechanism 60 also does not inhibit detachment of the optical transceiver 30.

As described above, according to the switch device 100A (100) according to the present embodiment, for example, an effect that it is possible to detach the optical transceiver 30 more easily or more speedily without inhibition by the heat dissipation mechanisms 50 and 60 in the state where the heat dissipation mechanisms 50 and 60 are fixed to the substrate 10 is achieved.

### Second Embodiment

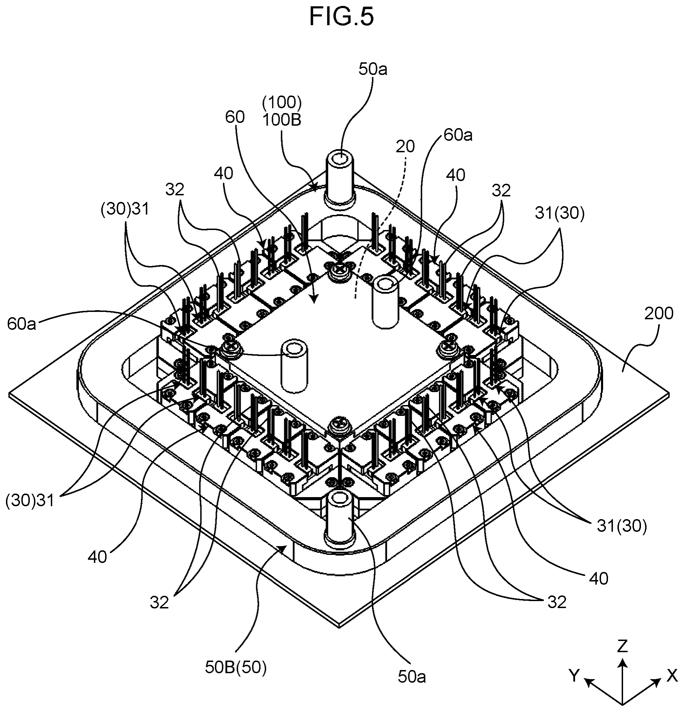

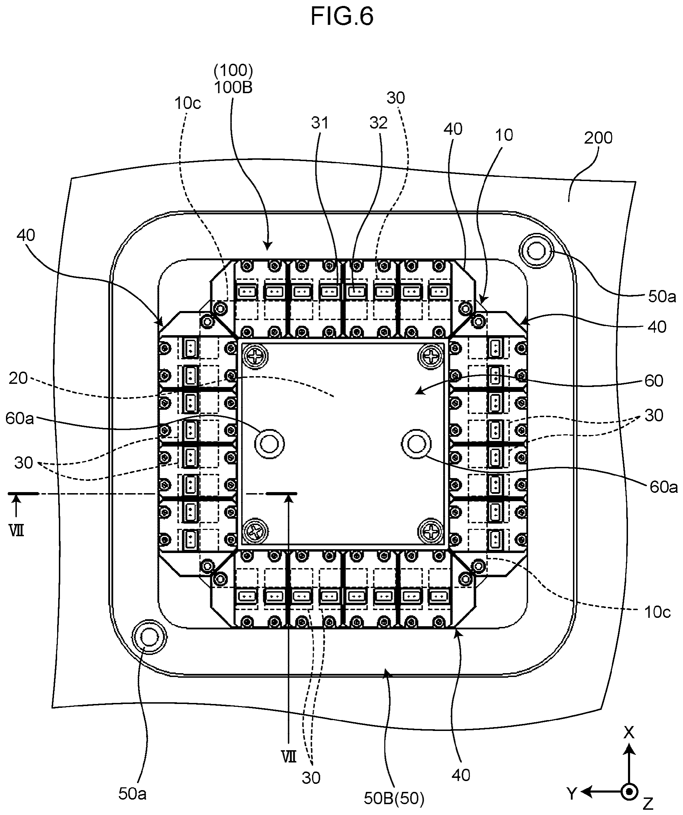

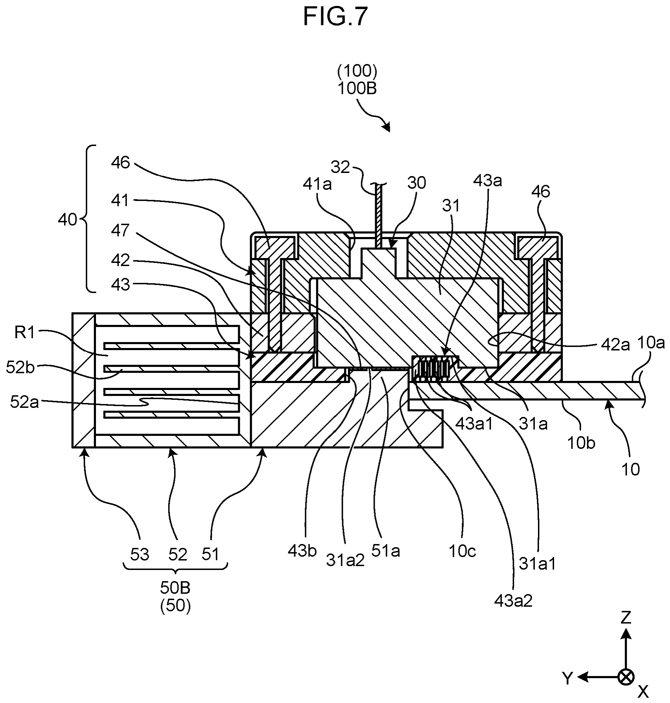

FIG. 5 is a perspective view of a switch device 100B (100) of a second embodiment. FIG. 6 is a plane view of the switch device 100B (100). FIG. 7 is a cross-sectional view of the switch device 100B (100) in an equivalent position to that in FIG. 4.

As is clear when FIGS. 5 and 6 are compared to FIGS. 1 and 2, the switch device 100B includes the optical transceivers 30, the fixation mechanism 40, and the heat dissipation mechanism 60 that are the same as in the above-described first embodiment. The substrate 10 is also the same as in the first embodiment. Thus, also in the present embodiment, the heat dissipation mechanism 60 does not inhibit detachment of the optical transceiver 30.

Note that, in the present embodiment, a heat dissipation mechanism 50B (50) differs from the heat dissipation mechanism 50A (50) of the above-described first embodiment. Specifically, as illustrated in FIG. 7, the base member 52 and the cover member 53 forming the storage chamber R1 for the liquid refrigerant have different shapes. Note that the connecting member 51 is the same as in the above-described first embodiment.

Also in the present embodiment, the base member 52 and the cover member 53 form the storage chamber R1 in which the liquid refrigerant is stored. Note that, in the present embodiment, the storage chamber R1 is positioned on a side opposite to the center of the substrate 10 with respect to the substrate 10, the optical transceiver 30, the intermediate member 42, the socket 43, and the connecting member 51.

The base member 52 is arranged on a side opposite to the center of the substrate 10 with respect to the connecting member 51, the socket 43, and the intermediate member 42. In a position separate from the side 10c of the substrate 10, the base member 52 extends approximately along the sides 10c in an approximately rectangular form and a circumferential form (endless form) in an approximately certain width in the direction along the surface 10b and in an approximately certain thickness in the Z-direction. The base member 52 makes contact with the connecting member 51 and is thermally connected to the connecting member 51 and also makes contact with the intermediate member 42 of the fixation mechanism 40 and is thermally connected to the intermediate member 42.

In the base member 52, a plurality of fin-like or pin-like protrusions 52b that protrude into the storage chamber R1 from an inner surface of the storage chamber R1 on a side close to the optical transceiver 30 are formed.

The cover member 53 is arranged on a side opposite to the connecting member 51 with respect to the base member 52, that is, on an outer-circumferential side and extends approximately along the sides 10c of the substrate 10 in an approximately rectangular form and a circumferential form (endless form) in an approximately certain width in the direction along the surface 10b and in an approximately equal thickness to that of the base member 52 in the Z-direction.

Note that arrangement of and the shapes of the base member 52 and the cover member 53 that form the storage chamber R1 are not limited to the example in FIG. 7, and they may be changed variously and may be exploited.

As described above, the optical transceivers 30 are arranged on the substrate 10 detachably in the Z-direction. On the other hand, in the present embodiment, the connecting member 51 is positioned out of alignment with the optical transceiver 30 in a direction opposite to the Z-direction, and the base member 52 and the cover member 53 that are included in the refrigerant storage configured to store a refrigerant are positioned out of alignment with the optical transceiver 30 in a direction intersecting with the Z-direction. In other words, the heat dissipation mechanism 50B (50) has a portion out of alignment with the optical transceiver 30 in the direction opposite to the Z- direction and a portion intersecting with the Z-direction with respect to the optical transceiver 30. In the state of being fixed to the substrate 10, the heat dissipation mechanism 50B (50) having such a configuration also does not inhibit detachment of the optical transceiver 30.

Thus, according to the switch device 100B (100) according to the present embodiment, for example, an effect that it is possible to detach the optical transceiver 30 more easily or more speedily without inhibition by the heat dissipation mechanisms 50 and 60 in the state where the heat dissipation mechanisms 50 and 60 are fixed to the substrate 10 is achieved.

### Third Embodiment

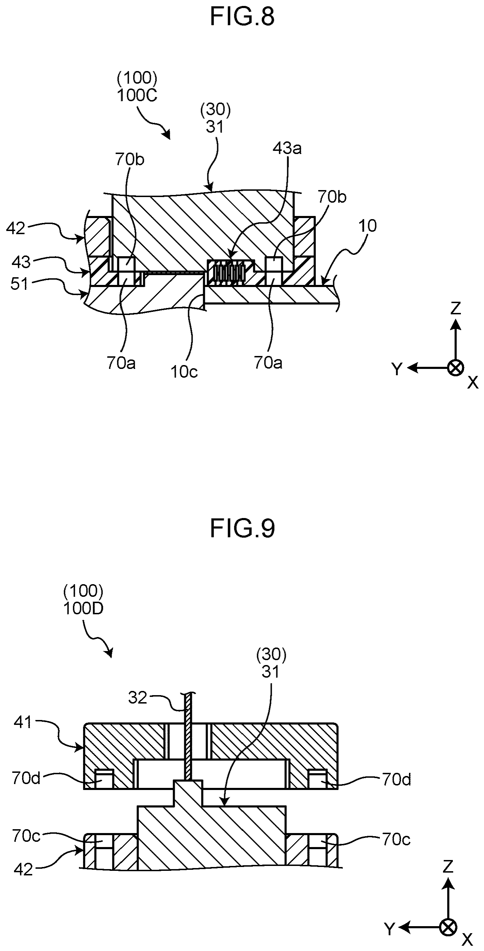

FIG. 8 is a cross-sectional view of a switch device 100C (100) of a third embodiment in an equivalent position to that in FIG. 4.

The present embodiment is different from the first and second embodiments in a mechanism that fixes the optical transceivers 30 to the substrate 10. Specifically, in the present embodiment, a magnet 70a that is arranged on the socket 43 and a magnet 70b that is arranged on the optical transceiver 30 are opposed to each other and form an adsorption mechanism using magnetic force. The magnetic force is set at a magnitude such that the optical transceiver 30 can be detached from the socket 43 by a force applied by an operating person or a robot. Note that the magnet 70a may be arranged in a site different from the socket 43.

According to such a configuration, for example, an effect that it is possible to detach the optical transceiver 30 more easily or more speedily and unnecessity of the upper member 41 and the fixation member 46 makes it possible to configure the switch device 100C smaller, lighter, or simpler and eventually it is possible to further reduce the time and costs required to manufacture the switch device 100 is achieved.

### Fourth Embodiment

FIG. 9 is an exploded cross-sectional view of a switch device 100D (100) of a fourth embodiment in an equivalent position to that in FIG. 4.

The present embodiment is different from the first third embodiments in a mechanism that fixes the upper member 41 to the intermediate member 42. Specifically, in the present embodiment, a magnet 70c that is arranged on the intermediate member 42 and a magnet 70d that is arranged on the upper member 41 are opposed to each other and form an adsorption mechanism using magnetic force. The magnetic force is set at a magnitude such that the upper member 41 can be detached from the intermediate member 42 by a force applied by an operating person or a robot.

According to such a configuration, for example, an effect that it is possible to detach the upper member and eventually the optical transceiver 30 more easily or more speedily and unnecessity of the fixation member 46 makes it possible to configure the switch device 100D smaller, lighter, or simpler and eventually it is possible to further reduce the time and costs required to manufacture the switch device 100 is achieved.

The embodiments of the present invention are exemplified above and the above-described embodiments are an example and are not intended to limit the scope of the invention. The above-described embodiments can be carried out in other various modes and various omissions, replacements, combinations and changes can be made without departing from the scope of the invention. Specification, such as each configuration and the shape, (the configuration, type, direction, model, size, length, width, thickness, height, number, arrangement, position, material, etc.,) can be changed as appropriate and exploited.

For example, even when the first heat dissipation mechanism has a configuration in which the first heat dissipation mechanism is arranged out of alignment with the optical transceiver in a direction intersecting with the first direction, it is clear that detachment of the optical transceiver is not inhibited.

### Industrial Applicability

The present invention is usable for a board assembly.

### Reference Signs List

10 SUBSTRATE (BOARD ASSEMBLY)
10a SURFACE (FIRST SURFACE)
10b SURFACE (SECOND SURFACE)
10c SIDE
20 SWITCH ASIC (SEMICONDUCTOR INTEGRATED CIRCUIT)
30 OPTICAL TRANSCEIVER
31 BODY
31a SURFACE
31a1 ELECTRIC INTERFACE (FIRST ELECTRIC INTERFACE)
31a2 HEAT DISSIPATION SURFACE (HEAT DISSIPATOR)
32 OPTICAL FIBER
40 FIXATION MECHANISM
41 UPPER MEMBER
41a OPENING
42 INTERMEDIATE MEMBER
42a OPENING
43 SOCKET
43a ELECTRIC INTERFACE (SECOND ELECTRIC INTERFACE)
43a1 ELECTRIC CONDUCTOR
43a2 ELECTRIC INSULATOR
43b OPENING
46 FIXATION MEMBER
47 HEAT CONDUCTING SHEET
50, 50A, 50B HEAT DISSIPATION MECHANISM (FIRST HEAT DISSIPATION MECHANISM, BOARD ASSEMBLY)
50a CONNECTION PORT
51 CONNECTING MEMBER
51a PORTION (CONNECTOR)
52 BASE MEMBER
52a GROOVE
52b PROTRUSION
52c GROOVE
53 COVER MEMBER
53a GROOVE
54 SEALING MEMBER
60 HEAT DISSIPATION MECHANISM (SECOND HEAT DISSIPATION MECHANISM, BOARD ASSEMBLY)
60a CONNECTION PORT
61 CONNECTING MEMBER
62 BASE MEMBER
62a CONCAVE PORTION
62b PROTRUSION
62c GROOVE
63 COVER MEMBER
64 SEALING MEMBER
70a TO 70d MAGNET
100, 100A TO 100D SWITCH DEVICE
200 MOTHERBOARD
R1 STORAGE CHAMBER
R2 STORAGE CHAMBER
X DIRECTION
Y DIRECTION
Z DIRECTION (FIRST DIRECTION)

## Claims

1. A board assembly comprising:
a substrate that has a first surface facing in a first direction and a second surface facing in a direction opposite to the first direction on a side opposite to the first surface and to which an optical transceiver including a first electric interface and a heat dissipator that face in the direction opposite to the first direction is fixed; and
a first heat dissipation mechanism that includes a connector adjacent to the heat dissipator in the first direction and thermally connected to the heat dissipator in a state where the optical transceiver is fixed to the substrate and that is fixed to the substrate,
wherein the board assembly is configured such that the optical transceiver is detachable in a state where the first dissipation mechanism is fixed to the substrate.

2. The board assembly according to claim 1, wherein the optical transceiver is arranged on the substrate detachably in the first direction, and
the first dissipation mechanism is arranged out of alignment with the optical transceiver in the direction opposite to the first direction.

3. The board assembly according to claim 1, wherein the optical transceiver is arranged on the substrate detachably in the first direction, and
the first dissipation mechanism is arranged out of alignment with the optical transceiver in a direction intersecting with the first direction.

4. The board assembly according to claim 1, wherein the optical transceiver is arranged on the substrate detachably in the first direction, and
the first dissipation mechanism has a portion out of alignment with the optical transceiver in the direction opposite to the first direction and a portion out of alignment with the optical transceiver in a direction intersecting with the first direction.

5. The board assembly according to claim 1, wherein the first heat dissipation mechanism is configured to perform heat transfer with a liquid refrigerant.

6. The board assembly according to claim 1, further comprising a second heat dissipation mechanism that is thermally connected to a semiconductor integrated circuit mounted on the first surface,
wherein the board assembly is configured such that the optical transceiver is detachable in a state where the second dissipation mechanism is fixed to the semiconductor integrated circuit.

7. The board assembly according to claim 6, wherein the second heat dissipation mechanism is configured to perform heat transfer with a liquid refrigerant.

8. The board assembly according to claim 7, wherein the first heat dissipation mechanism is configured to perform heat transfer with a liquid refrigerant, and
a flow channel for the liquid refrigerant in the first heat dissipation mechanism and a flow channel for the liquid refrigerant in the second heat dissipation mechanism are arranged in parallel.

9. The board assembly according to claim 1, wherein the substrate is configured such that a plurality of optical transceivers are fixable as the optical transceiver.

10. The board assembly according to claim 9, wherein the plurality of optical transceivers are arranged along a side of the substrate.

11. The board assembly according to claim 10, wherein the first heat dissipation mechanism is arranged along the side of the substrate.

12. The board assembly according to claim 1, wherein a second electric interface that is fixed to the substrate and that is electrically connected to the first electric interface includes an electric conductor and an electric insulator having a thermal conductivity lower than a thermal conductivity of the heat dissipator.
